Europäisches Patentamt

**European Patent Office**

**Office européen des brevets**

(19)

(11) Numéro de publication: **0 361 608 B1**

## FASCICULE DE BREVET EUROPEEN

(12)

(45) Date de publication de fascicule du brevet: **01.12.93**   (51) Int. Cl.5: **H04L 27/36**, H04B 1/62

(21) Numéro de dépôt: **89202405.0**

(22) Date de dépôt: **25.09.89**

(54) **Circuit de prédistorsion adaptative.**

(30) Priorité: **30.09.88 FR 8812805**

(43) Date de publication de la demande:
**04.04.90 Bulletin 90/14**

(45) Mention de la délivrance du brevet:
**01.12.93 Bulletin 93/48**

(84) Etats contractants désignés:
**DE FR GB IT SE**

(56) Documents cités:
**US-A- 4 291 277**

**THE BELL SYSTEM TECHNICAL JOURNAL,
vol. 62, no. 4, avril 1983, pages 1019-1033,
American Telephone and Telegraph Co.,
New York, US; A.A.M. SALEH et al.: "Adaptive
linearization of power amplifiers in digital
radio systems"**

(73) Titulaire: **LABORATOIRES D'ELECTRONIOUE
PHILIPS
3, Avenue Descartes
F-94450 Limeil-Brévannes(FR)**

(84) Etats contractants désignés:
**FR**

(73) Titulaire: **N.V. Philips' Gloeilampenfabrieken
Groenewoudseweg 1
NL-5621 BA Eindhoven(NL)**

(84) Etats contractants désignés:
**DE GB IT SE**

(72) Inventeur: **Sari, Hikmet Société Civile S.P.I.D.
209, rue de l'Université
F-75007 Paris(FR)**

(74) Mandataire: **Landousy, Christian
Société Civile S.P.I.D.
156, Boulevard Haussmann
F-75008 Paris (FR)**

EP 0 361 608 B1

## Description

L'invention concerne un circuit de prédistorsion adaptative pour système de transmission numérique qui transmet des données d'entrée à la cadence d'une horloge symbole de période T à l'aide d'un modulateur et d'un amplificateur de puissance qui distord les données, le circuit comprenant :

. un circuit de prédistorsion qui prédistord en sens opposé les données d'entrée avant leur passage dans l'amplificateur afin de transmettre les données d'entrée attendues,

. un circuit d'adaptation qui à partir d'une démodulation du flux de données transmises adapte continûment le circuit de predistorsion au flux des données d'entrée,

. et un filtre opérant une mise en forme du signal.

L'invention trouve ses applications dan les systèmes de transmission numérique tels que les modems de transmission de données, les faisceaux hertziens, les systèmes de communications spatiales.

Pour une utilisation efficace du spectre disponible, les systèmes de transmission numérique actuels, notamment les faisceaux hertziens et les systèmes du transmission de données sur le canal téléphonique, utilisent des modulations à grands nombres d'états de phase et d'amplitude. Or ces modulations sont très sensibles à toute sorte de distorsion, et bien entendu, aux distorsions non linéaires provenant des amplificateurs, des mélangeurs et d'autres circuits non-linéaires de le chaîne de transmission. Un point particulièrement critique en faisceaux hertziens et en transmission par satellite est la non-linéarité de l'amplificateur de puissance d'émission ou de l'amplificateur de puissance embarqué dans le cas des transmissions par satellite. Ces amplificateurs sont connus pour leurs caractéristiques non-linéaires. Si on les utilise dans leur zone linéaire on ne bénéficie pas totalement de leur puissance. Si on les fait fonctionner proche de leur puissance de saturation, ils distordent le signal d'une façon inacceptable. En pratique, étant donné un amplificateur de puissance, on fixe le niveau du signal émis de façon à établir un compromis entre le rapport signal à bruit et la distorsion non-linéaire subie par le signal. Ainsi le point de fonctionnement optimal de l'amplificateur est celui minimisant les effets conjoints du bruit additif du canal et de la distorsion non-linéaire de l'amplificateur. Pour des modulations à grand nombre d'états (MAQ64 et MAQ256 par exemple), ce point est loin de la puissance de saturation de l'amplificateur, ce qui signifie que celui-ci n'est pas utilisé d'une façon efficace. Pour augmenter son efficacité, on utilise couramment des techniques de prédistorsion (fixe ou adaptative) qui permettent de réduire l'effet de la non-linéarité de l'amplificateur de puissance sur le signal émis.

Une technique de prédistorsion couramment utilisée consiste à placer à l'étage de fréquence intermédiaire de l'émetteur un circuit non-linéaire approchant la fonction inverse de l'amplificateur de puissance dont on vise à compenser les non-linéarités. Si l'on savait synthétiser l'inverse exact de la fonction de l'amplficateur, cette technique permettrait d'avoir un signal parfait en sortie (sans aucune distorsion non-linéaire). Toutefois, ceci n'est pas réalisable, car l'inverse exact nécessiterait un circuit de complexité infinie. En pratique, on se contente de faire un approximation et le plus souvent on limite à l'ordre 3 la série de Taylor représentant la fonction non-linéaire de l'amplficateur et on synthétise un circuit de prédistorsion, également d'ordre 3, tel que les deux circuits cascadés n'aient plus de distorsion d'ordre 3. Des termes d'ordres supérieurs (ordre 5 et ordre 7) apparaissent en sortie mais de faible amplitude comparés à la distorsion d'ordre 3 initiale. Il en résulte ainsi une certaine amélioration des performances du système. Un inconvénient de ces circuits de prédistorsion à l'étage de fréquence intermédiaire réside dans le fait que ce sont des circuits analogiques. Ils sont difficiles à rendre adaptatifs et nécessitent de temps à autre une intervention pour les réajuster et compenser les variations de la réponse de l'amplificateur avec le temps et avec la température.

Une autre technique de prédistorsion, plus récente, consiste à modifier l'alphabet des données à émettre. Cette technique appelée "prédistorsion de données" ou "prédistorsion en bande de base" est connue du document brevet US 4 291 277 et de l'article de A.A.M. SALEH et J. SALZ "Adaptive linearization of power amplifiers in digital radio systems" Bell System Technical Journal Vo. 62 Avril 1983, pages 1019-1033.

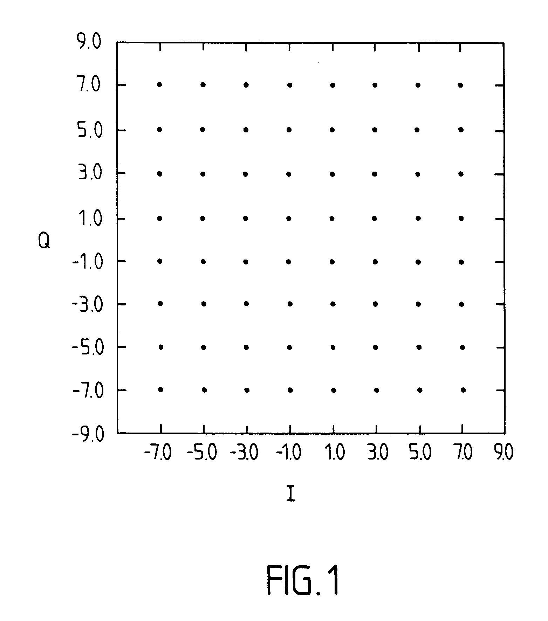

Dans l'article de A.A.M. SALEH et J. SALZ, la figure 1 est un schéma d'un circuit de prédistorsion adaptative qui fournit à l'entrée du modulateur une constellation distordue à partir de la constellation carrée d'origine, par exemple d'une modulation d'amplitude de deux porteuses en quadrature MAQ. L'amplificateur agit sur la constellation en produisant une nette compression et une nette rotation des points de grande amplitude. Pour compenser cet effet la constellation d'origine est distordue de sorte qu'elle reprend sa forme carrée originelle après son passage dans l'amplificateur de puissance. Ainsi, lorsque le circuit de distorsion est optimisé, il forme l'inverse de l'amplificateur de puissance (à un gain et à une phase près) et permet de compenser parfaitement les non-linéarités de l'amplificateur. Pour rendre ce circuit adaptatif, le signal est repris à la sortie de l'amplificateur, démodulé, puis échantillonné à la cadence d'émission des symboles 1/T et on compare ces échantillons au point correspondant de la constellation MAQ utilisée. Ces comparaisons permettent d'obtenir un signal de commande permettant d'optimiser le circuit de prédistorsion à l'aide d'un algorithme classique. Toutefois, le schéma utilisé sur la figure 1 est très simpliste, car il ne dispose d'aucun filtrage avant le modulateur, ni avant l'amplificateur de puissance. Il ne correspond donc pas à la solution généralement utilisée.

Un tel système est donné dans le document brevet US 4 291 277 où des filtres existent avant le modulateur. En effet dans les systèmes réels, on utilise toujours un filtrage de mise en forme spectrale de type Nyquist permettant de limiter la bande du signal tout en garantissant une interférence intersymbole nulle aux instants de décision. Ce filtrage est en général partagé équitablement entre l'émission et la réception pour maximiser le rapport signal à bruit également aux instances de décision. Dans de tels systèmes, l'effet de la non-linéarité de l'amplificateur est double : la constellation est non seulement déformée mais il apparaît une interférence intersymbole qui associe à chaque point de la constellation un nuage de points. Or, la technique de prédistorsion décrite ci-dessus ne permet pas de compenser ce deuxième effet.

Le but de l'invention est de réaliser un circuit de prédistorsion adaptative qui permette non seulement de corriger la constellation mais aussi de réduire considérablement la dispersion de chaque point de la constellation d'origine en un nuage de points.

Selon l'invention, ce but est atteint au moyen d'un circuit de prédistorsion adaptative tel que décrit dans le préambule caractérisé en ce que le circuit comprend un codeur qui, à partir des données numériques $a_k$, k entier, est apte à générer :

. sur une première voie, des données numériques $b_k$ qui sortent prédistordues d'un premier circuit de prédistorsion, en phase avec l'horloge symbole,

. sur une seconde voie, des données numériques $c_k$ qui sortent prédistordues d'un second circuit de prédistorsion, en opposition de phase avec l'horloge symbole,

les signaux $b_k$ et $c_k$ étant obtenus par un codage polynomial d'ordre n de type $F(D) = (1 + D)^n$ où D est un retard d'une demi-durée symbole et où F est une fonction appliquée aux données $a_k$, ces signaux ayant une mise en forme fréquentielle telle que

$$F(\omega) = \cos^n(\omega T/4) \text{ pour } |\omega| \leq 2\pi/T$$

n étant un entier positif, et tel que

$$b_k = \sum_{i=0}^{I} C_n^{2i} \, a_{k-i}$$

$$c_k = \sum_{j=0}^{J} C_n^{2j+1} \, a_{k-j}$$

où I est la partie entière de n/2
et où J est la partie entière de (n-1)/2
les coefficients $C_n^{2i}$ et

$$C_n^{2j+1}$$

étant les coefficients du Binôme de Newton, les données prédistordues des deux voies étant additionnées dans un additionneur

puis transformées en un signal analogique dans un convertisseur numérique-analogique, ce signal analogique étant filtré par le filtre pour une limitation de bande (-1/T,1/T) puis transmis au modulateur puis à l'amplificateur, l'adaptation s'opérant après la démodulation des données émises dans un circuit de démodulation à l'aide de deux circuits d'adaptation qui opèrent l'un en phase et l'autre en opposition de phase avec l'horloge symbole pour adapter chacun le circuit de prédistorsion correspondant.

Pour opérer le codage polynomial, le codeur peut comprendre une série de I registres à décalage dans lesquels circulent les données $a_{k-1}$, $a_{k-2}$ ... $a_{k-I}$, qui sont utilisées avec les données $a_k$ pour adresser au moins une mémoire qui opère le codage des données $a_k$ en données $b_k$ et $c_k$, les circuits de prédistorsion étant des mémoires vives qui délivrent les valeurs prédistordues aux voies en phase et en opposition de phase.

Dans le cas particulier où n = 2, pour lequel on a : $b_k = a_k + a_{k-1}$ et $c_k = 2a_k$ le codeur possède un seul registre à décalage et un additionneur pour déterminer $b_k$ qui adresse le premier circuit de prédistorsion, les données $a_k$ adressant directement le second circuit de prédistorsion, les données délivrées par les deux circuits de prédistorsion entrant dans deux ensembles de bascules opérant respectivement en phase et en opposition de phase avec l'horloge symbole.

Selon l'invention, on opère une prédistorsion à la cadence double de la fréquence d'émission des symboles. Pour cela, il est nécessaire d'effectuer une mise en forme spectrale d'émission fournissant des niveaux discrets à des instants séparés de T/2. Il faut remarquer tout d'abord qu'en utilisant un filtre de Nyquist de coefficient de retombée $\alpha$ quelconque avec $0 \leq \alpha \leq 1$ on détermine des niveaux discrets aux instants kT, c'est-à-dire en un point par durée symbole seulement. La seule exception est le filtre de Nyquist ayant un coefficient de retombée $\alpha = 1$. mais en plus de ce filtre particulier, il existe tout une classe de filtres qui présente la propriété requise.

Ces signaux sont obtenus par un codage polynomial de type :

$$(1) \qquad F(D) = \sum_{i=0}^{n} f_i . D^i$$

où D est un opérateur de retard d'une demi-durée symbole T/2 et les coefficients $f_i$ sont des entiers, le codage étant suivi d'un filtrage passe-bas idéal de bande (-1/T,1/T). Les signaux ainsi obtenus passent par un nombre fini d'états à tout instant kT/2 c'est-à-dire en deux points par durée symbole. Les polynômes conforment à la relation (1) qui sont les plus intéressants sont ceux qui localisent l'énergie du signal aux basses fréquences (pour minimiser l'interférence entre canaux adjacents). Les plus appropriés sont ceux qui peuvent être exprimés sous la forme :

$$(2) \qquad F(D) = (1 + D)^n$$

où n est un entier positif. Le paramètre n (avec l'alphabet de départ) détermine le nombre d'états que peut prendre le signal aux instances kT et aux instants kT + T/2. Le paramètre n ne doit pas être choisi trop grand pour limiter ce nombre d'états. Un tel codage, suivi d'un filtrage passe-bas idéal de bande (-1/T, 1/T) donne :

$$(3) \qquad F_e(w) = \begin{cases} \cos^n(wT/4), & |w| \leqslant 2\pi/T \\ 0, & \text{ailleurs} \end{cases}$$

pour le spectre du signal émis. Lorsque n = 2 cette classe de filtre donne précisément le filtrage de Nyquist avec un coefficient de retombée $\alpha = 1$. La relation (2) peut s'écrire sous la forme :

$$(4) \qquad F(D) = \sum_{i=0}^{n} C_n^i \, D^i$$

où les $C_n^i$ sont les coefficients de Binôme de Newton. La réponse impulsionnelle associée est :

$$(5) \qquad f(t) = \sum_{i=0}^{n} C_n^i \, \delta(t-iT/2).$$

Si le signal d'entrée est :

$$(6) \qquad s(t) = \sum_k a_k \, \delta(t-kT)$$

4

la sortie du codeur est :

$$(7) \quad r(t) = \sum_k \left( \sum_{i=0}^{I} c_n^{2i} a_{k-i} \delta(t-kT) + \sum_{j=0}^{J} c_n^{2j+1} a_{k-j} \delta(t-kT-T/2) \right)$$

où I est la partie entière de n/2 et J est la partie entière de (n-1)/2. Le signal r(t) peut donc être écrit sous la forme :

$$(8) \quad r(t) = \sum_k \left[ b_k \delta(t-kT) + c_k \delta(t-kT-T/2) \right]$$

avec

$$b_k = \sum_{i=0}^{I} c_n^{2i} a_{k-i}$$

et

$$c_k = \sum_{j=0}^{J} c_n^{2j+1} a_{k-j}.$$

Après filtrage passe-bas, le signal prend un nombre fini d'états donné par l'alphabet des symboles $b_k$ aux instants kT et un nombre fini d'états donné par l'alphabet des symboles $c_k$ aux instants kT + T/2. Pour n = 2, nous avons $b_k = a_k + a_{k-1}$ et $c_k = 2a_k$. Pour n = 3 on a $b_k = a_k + 3a_{k-1}$ et $c_k = 3a_k + a_{k-1}$.

Ainsi la classe de filtrage de mise en forme d'émission proposée (codage associé à un filtrage passe-bas) définit deux constellations. Le signal prend les niveaux de l'une des constellations aux instants kT et les niveaux de l'autre constellation aux instants kT + T/2.

Le filtrage passe-bas qui suit l'opération de prédistorsion à l'émission n'est pas obligé d'approcher le filtre pase-bas idéal tel que :

$$H(\omega) = \begin{cases} 1, & |\omega| < 2\pi/T \\ 0 & \text{ailleurs.} \end{cases}$$

Il peut être de la forme :

$$H(\omega) = \begin{cases} 1, & |\omega| < 2(1-\beta)\pi/T \\ 1/2[1-\sin(\dfrac{T}{2\beta}(|\omega|-2\pi/T))], & 2(1-\beta)\pi/T < |\omega| < 2(1+\beta)\pi/T \\ 0, & |\omega| > 2(1+\beta)\pi/T \end{cases}$$

où $\beta$ est un coefficient de retombée avec $0 \leq \beta \leq 1$, sans détruire la propriété de passage par zéro aux instants kT/2 (à l'exception de quelques valeurs de k) de la réponse impulsionnelle de la mise en forme d'émission.

L'invention sera mieux comprise à l'aide des figures suivants données à titre d'exemples non limitatifs qui représentent :

figure 1 : la constellation d'une modulation MAQ64.

EP 0 361 608 B1

figures 2A : une constellation MAQ64 distordue par l'amplificateur de puissance dans un système sans filtrage ou dans le cas où tout le filtrage est effectué après l'étage de l'amplificateur.

figure 2B : une constellation prédistordue optimisée pour compenser la distorsion illustrée sur la figure 2A selon l'art antérieur.

figure 3A : la constellation distordue par l'amplificateur telle qu'elle apparaît lorsque le filtrage global est équitablement partagé entre l'émission et la réception et la partie à l'émission est placée avant l'amplificateur.

figure 3B : avec la même situation que celle de la figure 3A, mais en incorporant le circuit de prédistorsion de l'art antérieur.

figure 4A : deux courbes de réponse impulsionnelle l'une pour un filtre de Nyquist avec un coefficient de retombée $\alpha$ égal à 1 et l'autre avec un coefficient de retombée différent de 1.

figure 4B : réponse fréquentielle d'un filtre de Nyquist ($\alpha$ quelconque).

figure 5 : un schéma de principe d'un circuit de prédistorsion adaptative selon l'invention.

figure 6 : un schéma détaillé d'un exemple de réalisation du codeur.

figure 7 : un schéma détaillé dans le cas où n = 2.

La figure 1 est un rappel de la représentation de la constellation d'un signal de type MAQ64. Les entrées I (en phase) et Q (en quadrature) du modulateur sont indépendantes et les symboles sur chaque voie prennent leurs valeurs dans un alphabet (±d, ±3d, ±5d, ±7d), où 2d est la distance minimale entre deux points adjacents de la constellation.

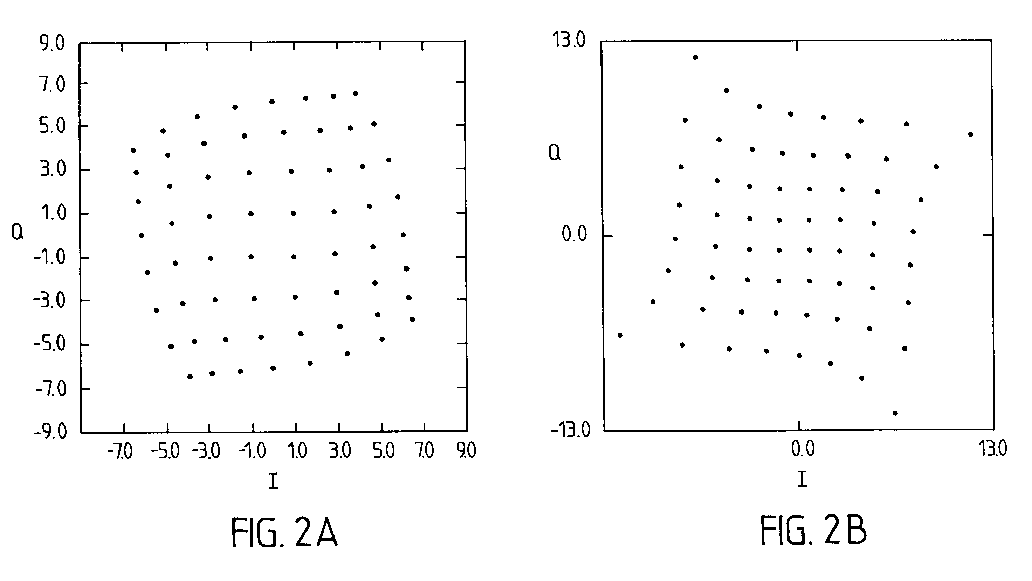

Pour être transmis le signal issu du modulateur est introduit dans un amplificateur de puissance qui est généralement utilisé à puissance réduite, c'est-à-dire dans une partie linéaire de sa caractéristique. A forte puissance cet amplificateur est non-linéaire et distord le signal de manière inacceptable. Si l'on observe une constellation de type MAQ64 à la sortie d'un tel amplificateur opérant proche de la saturation, on observe une constellation distordue comme celle représentée sur la figure 2A. Selon l'art antérieur il suffit alors de prédistordre dans le sens opposé la constellation selon le schéma de la figure 2B pour que en sortie de l'amplificateur on obtienne la constellation d'origine non déformée. Or une situation aussi simple n'est pas conforme à la réalité où il existe toujours un filtrage avant l'amplificateur de puissance notamment pour limiter la bande du signal. En absence de filtrage, le signal à l'entrée du modulateur varie par paliers une fois par durée symbole T. Ainsi, un circuit de prédistorsion agissant sur le signal à cadence 1/T permet une compensation parfaite. Par contre, lorsque le signal est filtré, il ne varie plus par paliers mais d'une façon continue. Pour une compensation parfaite de l'effet de la non-linéarité, il ne suffit plus d'observer le signal une fois par durée symbole T et de compenser la distorsion à ces moments là.

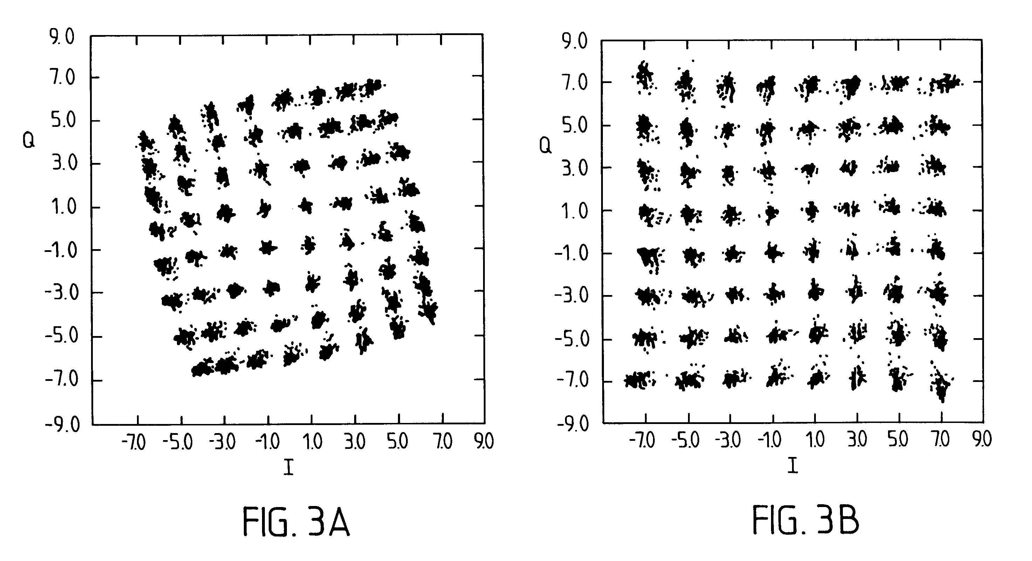

En présence d'un signal filtré la constellation à la sortie de l'amplificateur est représentée sur la figure 3A. Elle devient telle que représentée sur la figure 3B avec le circuit de prédistorsion de l'art antérieur. Ainsi chaque point de la constellation devient un nuage de points ce qui est inacceptable. Pour opérer avec un signal filtré il faut donc opérer la correction à plus d'un point par durée symbole. Pour cela selon l'invention on fait subir un codage approprié au signal d'entrée de façon à former un alphabet aux instances kT et un autre aux instants kT + T/2, une prédistorsion est ensuite effectuée séparément sur chacun des deux alphabets. Le signal résultant est ensuite filtré par un filtre passe-bas idéal de bande (-1/T,1/T). Selon l'invention ces moyens de codage et de filtrage cascadés doivent présenter une réponse impulsionnelle ayant des passages par zéro à tout instant kT/2 à l'exception de quelques valeurs de l'entier k.

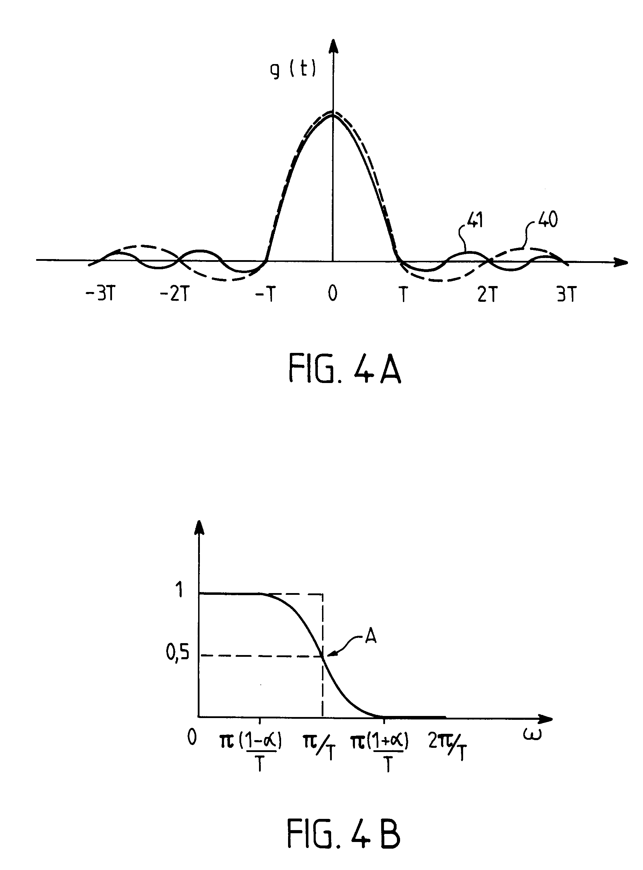

La courbe 40 de la figure 4A représente la réponse impulsionnelle d'un filtre de Nyquist ayant un coefficient de retombée $\alpha$ différent de 1. Cette courbe passe par zéro à tout instant kT, k≠0. Ce genre de mise en forme n'est donc pas adéquat pour la prédistorsion à la cadence double de l'émission des symboles. La courbe 41 représente la réponse impulsionnelle d'un filtre de Nyquist avec $\alpha$ = 1. Celle-ci passe par zéro pour des instants supplémentaires kT + T/2, les valeurs k = 0 et k = -1 étant à exclure. La figure 4B représente la réponse en fréquence d'un filtrage de Nyquist. La réponse est symétrique par rapport au point A(1/2T ; 0.5) et l'excès de bande par rapport à la bande de Nyquist (1/2T) est déterminé par le coefficient de retombée $\alpha$ (roll-off en langue anglaise). L'expression mathématique de la fonction de transfert est :

6

$$G(\omega) = \begin{vmatrix} 1, & |\omega| < (1-\alpha)\pi/T \\ \\ 1/2\ [1-\sin(\dfrac{T}{2\alpha}\ (|\omega|-\pi/T))],(1-\alpha)\pi/T<|\omega|<(1+\alpha)\pi/T \\ \\ 0, & |\omega| > (1+\alpha)\pi/T \end{vmatrix}$$

Le filtrage de Nyquist avec $\alpha = 1$ apparaît ainsi comme un cas particulier dans la classe de mise en forme spectrale selon l'invention. Il est équivalent à un codage particulier où le paramètre n de l'équation (2) est égal à 2 suivi d'un filtrage passe-bas idéal de bande (-1/T,1/T).

Dans le cas général (mais hors du cas particulier) le codage polynomial suivi du filtrage passe-bas aura une réponse semblable à la courbe 41 dans le sens où elle passe par zéro à des instants kT/2 mais avec une forme qui peut être différente.

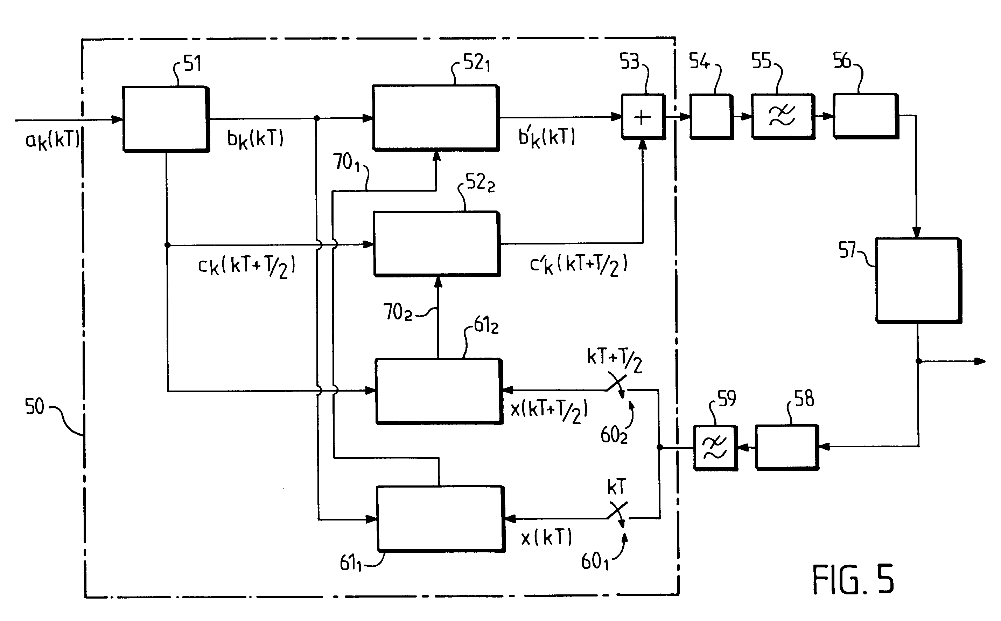

La figure 5 représente la partie située à l'émission d'un système de transmission numérique munie d'un circuit de prédistorsion adaptative 50 selon l'invention. Il comprend un codeur 51 qui à partir des données $a_k$ génère des données $b_k$ et $c_k$ respectivement aux instants kT et KT + T/2 codées selon l'invention. Les données $b_k$ et $c_k$ entrent respectivement dans des circuits de prédistorsion $52_1$, $52_2$ qui délivrent respectivement des données prédistordues $b'_k$ et $c'_k$. Elles sont additionnées dans l'additionneur 53. le signal ainsi obtenu traverse un convertisseur numérique-analogique 54, un filtre passe-bas 55, un modulateur 56 et un amplificateur de puissance 57 puis est transmis à une antenne d'émission. Pour assurer l'adaptation, la sortie de l'amplificateur 57 est démodulée dans un démodulateur 58 puis filtrée dans un filtre passe-bas 59. La sortie du filtre 59 est échantillonnée par deux échantillonneurs, le premier $60_1$ aux instances kT et le second $60_2$ aux instants kT + T/2 qui fournissent respectivement les échantillons x(kT) et x(kT + T/2) à deux circuits d'adaptation $61_1$ et $61_2$. Ceux-ci comparent respectivement les échantillons x(kT) et x(kT + T/2) avec les données $b_k$ et $c_k$. Un algorithme classique calcule par exemple l'écart entre les deux entrées de chaque circuit d'adaptation qui délivre en conséquence une mise à jour des circuits de prédistorsion.

La méthode la plus appropriée pour réaliser les circuits de prédistorsion est l'utilisation de mémoires vives RAM. Dans une telle réalisation, une RAM sera adressée par les mots $b_k$ aux instants kT et sa sortie constitue le train des symboles prédistordus $b'_k$. L'autre RAM sera adressée par les mots $c_k$ aux instants KT + T/2 pour fournir le train $c'_k$. Les mémoires contiennent donc les valeurs prédistordues des deux alphabets respectifs.

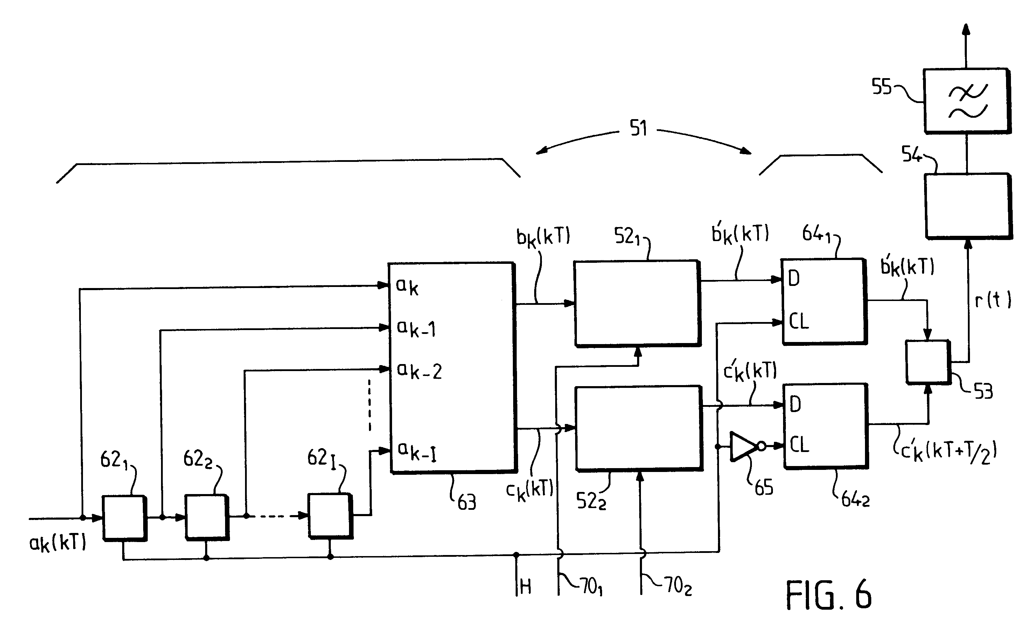

La figure 6 représente un exemple de réalisation du codeur 51. Il comprend une série de I registres à décalage $62_1$, $62_2$, ... $62_I$ qui a un instant donné stocke respectivement les données $a_{k-1}$, $a_{k-2}$, ... $a_{k-I}$ sur la commande de l'horloge H. L'ensemble des données $a_k$, $a_{k-1}$,...,$a_{k-I}$ sert à adresser une mémoire 63, par exemple une mémoire morte programmable PROM qui opère le codage des données $a_k$ en données $b_k$ et $c_k$. Celles-ci entrent respectivement dans des mémoires vives $52_1$, $52_2$ qui opèrent la prédistorsion des données $b_k$ en données $b'_k$ et les données $c_k$ en données $c'_k$, toutes deux en phase avec l'horloge symbole H. Les données $b'_k$ et $c'_k$ sont alors introduites chacune dans deux ensembles de bascules $64_1$, $64_2$ qui sont commandés l'un $64_1$ par l'horloge symbole H et l'autre $64_2$ par l'horloge symbole inversée par un inverseur 65. Ainsi l'ensemble de bascules $64_1$ délivre les données $b'_k$ aux instants kT soit $b'_k(kT)$ et l'ensemble de bascules $64_2$ délivre les données $c'_k$ aux instants kT + T/2 soit $c'_k(kT + T/2)$. Pour réaliser l'addition des données (voir figure 5), celles-ci sont multiplexées dans le dispositif 53 pour délivrer le signal numérique r(t) tel que :

$$r(t) = \Sigma\ \{b'_k.\delta(t-kT) + c'_k.\delta(t-kT-T/2)].$$

Ce signal numérique r(t) passe dans un convertisseur numérique-analogique 54 puis dans le filtre analogique 55 qui précède le modulateur. Ce filtre 55 peut également être un filtre numérique placé avant le convertisseur numérique-analogique 54.

De la même façon l'opération effectuée par les deux ensembles de bascules $64_1$, $64_2$ qui génèrent les données $b'_k(kT)$ et $c'_k(kT + T/2)$ en phase et en opposition de phase avec l'horloge symbole, peut également être effectuée avant les circuits de prédistorsion $52_1$ et $52_2$. Ceux-ci reçoivent leur mise à jour respectivement des circuits d'adaptation $61_1$ et $61_2$ (connexion $70_1$ et $70_2$, figure 5).

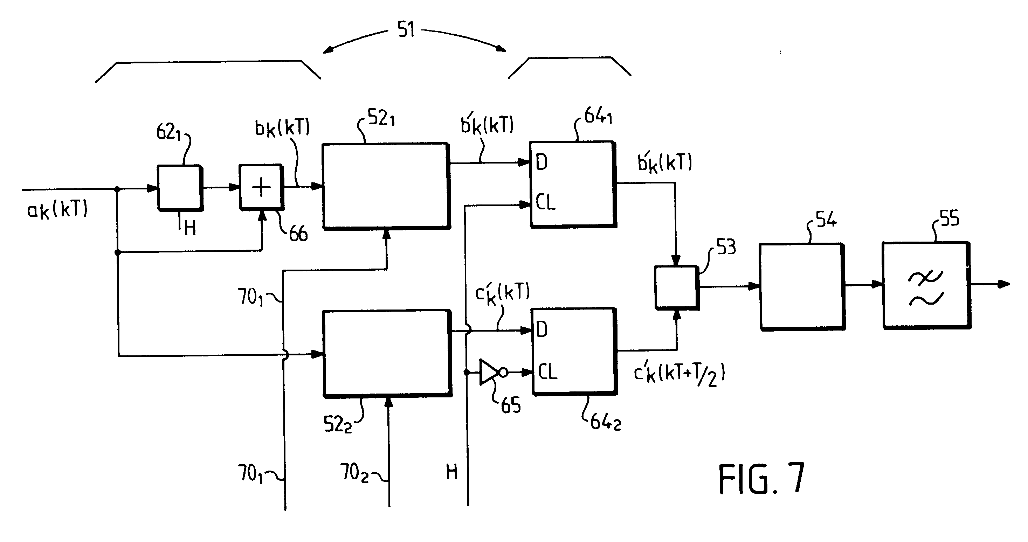

La figure 7 corespond à un cas particulier du cas représenté sur la figure 6. En effet, lorque n = 2 dans l'equation (2) le schéma de la figure 7 se simplifie et ne nécessite alors qu'un seul registre à décalage $62_1$

qui retarde les données $a_k$ de une durée symbole. La mise en forme des signaux correspond alors à un filtrage de Nyquist avec $\alpha = 1$. Les données $a_k(kT)$ et les données retardées $a_{k-1}(kT-T)$ sont additionnées dans l'additionneur 66 qui se substitue ainsi à la mémoire morte 63 de la figure 6 pour délivrer

$$b_k(kT) = a_k(kT) + a_{k-1}(kT-T).$$

Le circuit de prédistorsion $52_1$ est adressé par les données $b_k(kT)$ Le circuit de prédistorsion $52_2$ est adressé par les données $2a_k(kT)$, le coefficient 2 étant programmé dans le circuit de prédistorsion $52_2$. Les deux circuits de prédistorsion $52_1$, $52_2$ sont par exemple les mémoires vives RAM qui reçoivent leur mise à jour respectivement des circuits d'adaptation $61_1$ et $61_2$ (connexions $70_1$ et $70_2$ figure 5). Les sorties des circuits de prédistorsion $52_1$ et $52_2$ sont traitées comme dans le cas de la figure 6 respectivement par les deux ensembles de bascules $64_1$ et $64_2$ puis multiplexées par le dispositif 53, puis transmises au convertisseur numérique-analogique 54 et au filtre 55.

Le signal émis par l'émetteur puis reçu à l'autre extrémité du système de transmission par un récepteur doit à la réception subir un filtrage qui est déterminé de façon à ce que globalement le filtrage de l'émetteur associé au filtrage du récepteur corresponde à un filtrage de Nyquist ayant un coefficient de retombée adéquat. C'est ce coefficient qui détermine la protection contre l'interférence des canaux adjacents. Pour illustrer les résultats obtenus par l'invention prenons, à titre d'exemple, un système MAQ64 à 140 Mbits/s opérant sur un plan de fréquence avec un espacement entre canaux de 30 MHz. Pour ce système, un coefficient de retombée $\alpha = 0,5$ dans un filtrage de Nyquist équitablement réparti entre l'émission et la réception fournit une protection de 28 dB. Pour atteindre la même protection dans le système selon l'invention le filtrage global doit avoir un coefficient de retombée plus faible. Dans cet exemple le choix de $n = 2$ comme ordre du polynôme de codage à l'émission nécessite un coefficient de retombée de 0,25 dans le filtrage global pour atteindre une protection de 28 dB contre l'interférence des canaux adjacents.

Selon l'invention, avec un système MAQ256 à 2x140 Mbits par seconde sur un plan de fréquence avec un espacement entre canaux de 40MHz, le gain apporté par l'invention est d'environ 3dB comparé aux techniques de prédistorsion antérieures.

**Revendications**

1. Circuit de prédistorsion adaptative (50) pour système de transmission numérique qui transmet des données d'entrée à la cadence d'une horloge symbole de période T à l'aide d'un modulateur (56) et d'un amplificateur de puissance (57) qui distord les données, le circuit comprenant :
   - un circuit de prédistorsion ($52_1$,$52_2$) qui prédistord en sens opposé les données d'entrée avant leur passage dans l'amplificateur afin de transmettre les données d'entrée attendues,
   - un circuit d'adaptation ($61_1$,$61_2$) qui à partir d'une démodulation du flux de données transmises adapte continûment le circuit de prédistorsion au flux des données d'entrée,
   - et un filtre (55) opérant une mise en forme du signal,

   caractérisé en ce que le circuit comprend un codeur (51) qui, à partir des données numériques $a_k$, k entier, est apte à générer :
   - sur une première voie, des données numériques $b_k$ qui sortent prédistordues d'un premier circuit de prédistorsion ($52_1$), en phase avec l'horloge symbole,
   - sur une seconde voie, des données numériques $c_k$ qui sortent prédistordues d'un second circuit de prédistorsion ($52_2$), en opposition de phase avec l'horloge symbole,

   les signaux $b_k$ et $c_k$ étant obtenus par un codage polynomial d'ordre n de type $F(D) = (1+D)^n$ où D est un retard d'une demi-durée symbole et où F est une fonction appliquée aux données $a_k$, ces signaux ayant une mise en forme fréquentielle telle que

   $$F(\omega) = \cos^n(\omega T/4) \text{ pour } |\omega| \leq 2\pi/T$$

   n étant un entier positif, et tel que

$$b_k = \sum_{i=0}^{I} c_n^{2i} \, a_{k-i}$$

$$c_k = \sum_{j=0}^{J} c_n^{2j+1} \, a_{k-j}$$

où I est la partie entière de n/2
et où est la partie entière de (n-1)/2
le coefficients $c_n^{2i}$ et

$$c_n^{2j+1}$$

étant les coefficients du Binôme de Newton, les données prédistordues des deux voies étant additionnées dans un additionneur (53) puis transformées en un signal analogique dans un convertisseur numérique-analogique (54), ce signal étant filtré par le filtre (55) pour une limitation de bande (-1/T, 1/T) puis transmis au modulateur puis à l'amplificateur (57), l'adaptation s'opérant après la démodulation des données émises dans un circuit de démodulation (59) à l'aide de deux circuits d'adaptation ($61_1$,$61_2$) qui opèrent l'un en phase et l'autre en opposition de phase avec l'horloge symbole pour adapter chacun le circuit de prédistorsion correspondant.

2. Circuit de prédistorsion adaptative selon la revendication 1, caractérisé en ce que le codeur (51) comprend une série de I registres à décalage ($62_1$-$62_I$) dans lesquels circulent les données $a_{k-1}$, $a_{k-2}$ ... $a_{k-I}$, qui sont utilisées avec les données $a_k$ pour adresser au moins une mémoire (63) qui opère le codage des données $a_k$ en données $b_k$ et $c_k$, les circuits de prédistorsions ($52_1$,$52_2$) étant des mémoires vives qui délivrent les valeurs prédistordues aux voies en phase et en opposition de phase.

3. Circuit de prédistorsion adaptative selon la revendication 1, caractérisé en ce que n = 2 pour lequel on a : $b_k = a_k + a_{k-1}$ et $c_k = 2a_k$, le codeur possédant un seul registre à décalage et un additionneur pour déterminer $b_k$ qui adresse le premier circuit de prédistorsion, les données $a_k$ adressant directement le second circuit de prédistorsion, les données délivrées par les deux circuits de prédistorsion entrant dans deux ensembles de bascules ($64_1$,$64_2$) opérant respectivement en phase et en opposition de phase avec l'horloge symbole.

**Claims**

1. Adaptive pre-distortion circuit (50) for a digital transmission system which transmits input data at the rate of a symbol clock having a period T with the aid of a modulator (56) and a power amplifier (57) which distorts the data, the circuit comprising:

    . a pre-distortion circuit ($52_1$, $52_2$) pre-distorting in the opposite sense the input data prior to their entering the amplifier in order to transmit the expected input data,
    . an adaptation circuit ($61_1$, $61_2$) continuously adapting the pre-distortion circuit to the stream of input data in response to a demodulation of the stream of transmitted data,
    . and a filter (55) performing a signal shaping,
   characterized in that the circuit comprises a encoder (51) suitable for generating, on the basis of digital data $a_k$, where k is an integer:
    . on a first path, digital data $b_k$ leaving a first pre-distortion circuit ($52_1$) in a pre-distorted condition, in-phase with the symbol clock,
    . on a second path, digital data $c_k$ leaving a second pre-distortion circuit ($52_2$) in a pre-distorted condition, in phase-opposition to the symbol clock,
   the signals $b_k$ ad $c_k$ being obtained by means of a $n^{th}$ order polynomial encoding of the type of $F(D) = -(1 + D)^n$, where D is a delay of a half symbol period and where F is a function applied to the data $a_k$, these signals having a frequency shaping such that

$$F(\omega) = \cos^n(\frac{\omega T}{4}) \quad \text{for} \quad |\omega| \leq \frac{2\pi}{T}$$

where n is a positive integer and these signals are encoded such that

$$b_k = \sum_{i=0}^{I} c_n^{2i} a_{k-i}$$

$$c_k = \sum_{j=0}^{J} c_n^{2j+1} a_{k-j}$$

where I is the integral part of n/2
and where J is the integral part of (n-1)/2
the coefficients $C_n^{2i}$ and

$$C_n^{2i+1}$$

being the coefficients of Newton's binomial theorem, the pre-distorted data of the two paths being added together in an adder (53), then transformed into an analog signal by a digital-to-analog converter (54), this analog signal being filtered by the filter (55) for obtaining a bandwidth limitation (-1/T, 1/T), then transmitted to the modulator thereafter to the amplifier (57), while the adaptation is effected after the demodulation of the transmitted data in a demodulation circuit (59) with the aid of two adaptation circuits ($61_1$, $61_2$), one of which operating in-phase and the other in phase-opposition to the symbol clock for adapting each the corresponding pre-distortion circuit.

2. Adaptive pre-distortion circuit as claimed in Claim 1, characterized in that the encoder (51) comprises a series of I shift registers ($62_1$, $62_2$, ... $62_I$) in which the data $a_{k-1}$, $a_{k-2}$, ... $a_{k-I}$ are passing, which, together with the data $a_k$ are used for addressing at least one memory (63) which performs the encoding of the data $a_k$ into the data $b_k$ and $c_k$, the pre-distortion circuits ($52_1$, $52_2$) being random access memories delivering the pre-distorted values to the in-phase and the opposite-phase paths.

3. Adaptive pre-distortion circuit as claimed in Claim 1, characterized in that n = 2 for which $b_k = a_k + a_{k-1}$ and $c_k = 2a_k$, the encoder comprising a single shift register and an adder for determining $b_k$ which addresses the first pre-distortion circuit, the data $a_k$ directly addressing the second pre-distortion circuit, the data delivered by the two pre-distortion circuits entering two sets of flip-flops ($64_1$, $64_2$) which operate respectively, in-phase and in phase-opposition to the symbol clock.

**Patentansprüche**

1. Adaptive Vorverzerrungsschaltung (50) für ein digitales Übertragungssystem, das mit Hilfe eines Modulators (56) und eines die Daten verzerrenden Leistungsverstärkers (57) Eingangsdaten mit einer Symboltaktfrequenz T uberträgt, wobei diese Schaltung die nachfolgenden Elemente aufweist:
   . eine Vorverzerrungsschaltung ($52_1$, $52_2$), welche die Eingangsdaten vor ihrem Durchgang in dem Verstärker zum Übertragen der empfangenen Eingangsdaten in entgegengesetztem Sinne vorverzerrt,
   . eine Anpassungsschaltung ($61_1$, $61_2$), die ausgehend von einer Demodulation des Stromes übertragener Daten kontinuierlich die Vorverzerrungsschaltung an den Strom von Eingagsdaten anpaßt,

. und ein Filter (55) zum Formen des Signals,

dadurch gekennzeichnet, daß die Schaltung einen Codierer (51) aufweist, der dazu geeignet ist, auf Basis digitaler Daten $a_k$ (wobei k eine ganze Zahl ist) Folgendes zu erzeugen:

. über eine erste Strecke digitale Daten $b_k$, die in vorverzerrtem Zustand gleichphasig zu dem Symboltakt eine erste Vorverzerrungsschaltung ($52_1$) verlassen,

. über eine zweite Strecke digitale Daten $c_k$, die in vorverzerrtem Zustand in Gegenphase zu dem Symboltakt eine zweite Vorverzerrungsschaltung ($52_2$) verlassen,

wobei die Signale $b_k$ und $c_k$ durch eine polynominale Codierung n. Ordnung vom Typ $F(D) = (1 + D)^n$, wobei D eine Verzögerung um eine halbe Symbolperiode und F eine den Daten $a_k$ zugeführte Funktion ist, wobei diese Signale eine Frequenzform haben wie folgt:

$$F(\omega) = \cos^n\left(\frac{\omega T}{4}\right) \text{ für } |\omega| \leq \frac{2\pi}{T}$$

wobei n eine positive ganze Zahl ist und wobei diese Signale derart codiert werden, daß

$$b_k = \sum_{i=0}^{I} C_n^{2i} a_{k-1}$$

$$c_k = \sum_{j=0}^{J} C_n^{2j+1} a_{k-j}$$

wobei I der ganze Teil von n/2 ist
und wobei J der ganze Teil von (n-1)/2 ist,
wobei die Koeffizienten $C_n^{2i}$ und

$$C_n^{2i+1}$$

die Koeffizienten des Binominalsatzes sind, wobei die vorverzerrten Daten der beiden Strecken in einem Addierer (53) zuammengezählt und danach durch einen Digital-Analog-Wandler (54) in ein analoges Signal umgewandelt werden, wobei dieses analoge Signal zum Erhalten einer Bandbreitenbegrenzung (-1/T, 1/T) durch das Filter (55) gefiltert, danach zu dem Modulator und dann zum Verstärker (57) übertragen wird, während die Anpassung nach der Demodulation der übertragenen Daten in einer Demodulationsschaltung (59) mit Hilfe zweier Anpassungsschaltungen ($61_1$, $61_2$) erfolgt, von denen zum Anpassen jeder derselben an die entsprechende Vorverzerrungsschaltung die eine gleichphasig und die andere in Gegenphase zu dem Symboltakt arbeitet.

**2.** Adaptive Vorverzerrungsschaltung nach Anspruch 1, dadurch gekennzeichnet, daß der Codierer (51) eine Reihe von I Schieberegistern ($62_1$ ...$62_I$) aufweist, in denen die Daten $a_{k-1}$, $a_{k-2}$, ... $a_{k-I}$ umlaufen, die zusammen mit den Daten $a_k$ zum Adressieren mindestens eines Speichers (63) verwendet werden, der die Codierung der Daten $a_k$ in die Daten $b_k$ und $c_k$ durchführt, wobei die Vorverzerrungsschaltungen ($52_1$, $52_2$) Speicher mit beliebigem Zugriff sind, welche die vorverzerrten Werte zu den gleichphasigen und gegenphasigen Strecken liefern.

**3.** Adaptive Vorverzerrungsschaltung nach Anspruch 1, dadurch gekennzeichnet, daß n = 2 ist, wodurch gilt: $b_k = a_k + a_{k-1}$ und $c_k = 2a_k$, wobei der Codierer ein einziges Schieberegister und einen Addierer aufweist zum Bestimmen von $b_k$, der die erste Vorverzerrungsschaltung adressiert, wobei die Daten $a_k$ unmittelbar die zweite Vorverzerrungsschaltung adressieren, wobei die von den beiden Vorverzerrungsschaltungen gelieferten Daten in die beiden Sätze von Flip-Flop-Schaltungen ($64_1$, $64_2$) hineingehen, die in Phase bzw. in Gegenphase zu dem Symboltakt arbeiten.

FIG.1

FIG. 2A

FIG. 2B

EP 0 361 608 B1

FIG. 3A

FIG. 3B

EP 0 361 608 B1

FIG. 4 A

FIG. 4 B

15

FIG. 5

EP 0 361 608 B1

FIG. 6

EP 0 361 608 B1

FIG. 7

EP 0 361 608 B1